(19) Europäisches Patentamt
European Patent Office
Office européen des brevets

(11) EP 0 481 777 B1

(12) **EUROPEAN PATENT SPECIFICATION**

(45) Date of publication and mention
of the grant of the patent:
**03.05.2006 Bulletin 2006/18**

(51) Int Cl.:
*H01L 21/336* *(2006.01)*    *H01L 21/3205* *(2006.01)*

(21) Application number: **91309571.7**

(22) Date of filing: **17.10.1991**

(54) **Method of manufacturing gate insulated field effect transistors**

Verfahren zur Herstellung Feld-Effekt-Transistoren mit isoliertem Gate

Procédé pour la fabrication des transistors à effet de champs à grille isolée

(84) Designated Contracting States:
**DE FR GB**

(30) Priority: **17.10.1990 JP 27816090**

(43) Date of publication of application:
**22.04.1992 Bulletin 1992/17**

(73) Proprietor: **SEMICONDUCTOR ENERGY
LABORATORY CO., LTD.
Atsugi-shi, Kanagawa-ken 243-0036 (JP)**

(72) Inventors:
• **Yamazaki, Shunpei
Setagaya-ku,
Tokyo 156 (JP)**
• **Zhang, Hongyong
Yamato-shi,
Kanagawa-ken, 242 (JP)**

(74) Representative: **Milhench, Howard Leslie et al
R.G.C. Jenkins & Co.
26 Caxton Street
London SW1H 0RJ (GB)**

(56) References cited:
| EP-A- 0 404 101 | EP-A- 0 436 185 |
| EP-A- 0 440 154 | US-A- 3 627 662 |
| US-A- 4 091 527 | |

• PANKOVE J.I.: Semiconductors and Semimetals, vol. 21, part A, Academic Press, Inc., 1984, pp. 55-65
• Proc. of the SID, Los Angeles US, vol. 30, no. 2, 1989, pages 137-141
• IEEE Transactions on Electron Devices, vol. 34, no. 10, 1987, pages 2124-2128
• Thin Solid Films, Lausanne CH, vol. 175, no.1, 1989, pages 37-42
• PATENT ABSTRACTS OF JAPAN vol. 013, no. 220 (E-762) 23 May 1989 & JP 01 031 466 A (NIPPON TELEGR & TELEPH CORP) 01 February 1989
• PATENT ABSTRACTS OF JAPAN vol. 010, no. 107 (C-341) 22 April 1986 & JP 60 238 479 A (NICHIDEN ANELVA KK) 27 November 1985
• PATENT ABSTRACTS OF JAPAN vol. 012, no. 056 (C-477) 19 February 1988 & JP 62 202 078 A (SEIKO EPSON CORP) 05 September 1987
• THOMSON C.V.; SMITH H.I.: 'Surface-energy-driven secondary grain growth in ultathin (smaller than 100 nm) films of silicon' APPLIED PHYSICS LETTERS vol. 44, no. 6, 15 March 1984, pages 603 - 605

**Description**

Field of the Invention

The present invention relates to a method of manufacturing field effect transistors and, more particularly but not exclusively to a method of manufacturing thin film gate insulated field effect transistors comprising polycrystalline semiconductor films.

Background of the Invention

The prior art includes methods utilizing low pressure CVD for the deposition of polycrystalline semiconductor thin films at temperatures ranging from 550° C to 900° C. Recently, with the development of liquid crystal panels having wide display areas, the need has arisen for a deposition technique which will enable polycrystalline semiconductor films to be provided over large area substrates.

Polycrystalline films are formed by depositing amorphous semiconductor films by low pressure CVD and then recrystallizing the amorphous films, since direct deposition of polycrystalline films over wide areas is difficult for the reason of reaction temperature. Furthermore, it is very difficult to deposit uniform semiconductor films by low pressure CVD. Problems also arise with plasma CVD which requires long deposition times.

Sputtering on the other hand is excellent in this sense. In particular, there are the following advantages when films are deposited by magnetron sputtering:

1) The surfaces of substrates are less damaged by high energy electrons since the electrons are confined to the vicinity of the target;
2) Wide areas can be coated at lower temperatures; and
3) No dangerous gas is used so that safe and practicable processes are ensured.

The sputtering is conventionally carried out without hydrogen because the electric characteristics of hydrogenated amorphous semiconductors deposited by sputtering are not so good as to satisfy the requirements of channel formation for transistors. Semiconductor films deposited by sputtering, however, have a disadvantage that thermal crystallization thereof is very difficult.

JP-A-0 131 466 discloses methods as defined in the pre-characterising portions of appended claims 1 and 8.

SUMMARY OF THE INVENTION

It is thus desired to provide a method of manufacturing gate insulated field effect transistors comprising polycrystalline semiconductor films over a wide substrate area.

According to one aspect of the present invention there is provided a method of manufacturing field effect transistors in accordance with claim 1.

According to another aspect of the present invention, there is provided a method of manufacturing field effect transistors in accordance with claim 8.

The oxide insulating film may be deposited in the same manner as the deposition of the semiconductor film described hereinafter except that the sputtering atmosphere is replaced by an oxidizing atmosphere.

According to the present invention, the semiconductor film is deposited in an amorphous phase in an atmosphere comprising hydrogen. The amorphous semiconductor is then subjected to thermal treatment in order to convert the amorphous phase to a polycrystalline phase. This recrystatlization takes place easily as compared to the conventional case abovementioned where no hydrogen is introduced. The reason for this is considered to be as explained in the following. In the conventional case, amorphous semiconductors such as a-Si are deposited and form a certain type of microstructure in which the distribution of silicon atoms is uneven. This microstructure hinders the progress of recrystallization. The inventors of the present invention have confirmed that the formation of such a microstructure is prevented by introducing hydrogen into the semiconductor film, so that the resulting film can be easily recrystallized by thermal treatment. The average diameter of polycrystals formed after the thermal treatment is of the order of 5Å to 400Å. The proportion of hydrogen introduced into the film may be no higher than 5 atom %.

Another important feature of the semiconductor film produced in accordance with the present invention is lattice distortion which enables close connection between polycrystals at interfaces thereof, and the method of the invention enables films which possess lattice distortion to be obtained. This feature helps to cancel out the formation of barriers at the crystal interfaces, whereas in the absence of such lattice distortions, impurity atoms such as oxygen tend to collect at the interfaces so forming crystal barriers which hinder transportation of carriers. Because of this, the mobility (field mobility) of electrons in the semiconductor film formed is improved to as high as 5 to 300 cm$^2$/V·S. The invention thus provides an impurity-proof manufacturing method. Even in the case of relatively many oxygen atoms occurring in the semiconductor film, the manufacturing method of this invention can still produce acceptable transistors.

Furthermore, semiconductor film deposited by sputtering in accordance with the invention is so fine and dense as not to allow oxidation to reach to the inside of the film and only very thin oxide films are formed at the surface thereof, whereas semiconductor film deposited by plasma CVD includes a relatively high proportion of its amorphous phase which enables oxidation to progress into the inside of the semiconductor. This fine structure helps to reduce interfacial barriers between crystals in association with lattice distortion.

The atmosphere in which sputtering for deposition of the semiconductor film is carried out is a mixture of hydrogen and an inert gas such as Ar and/or He. The existence of hydrogen in the sputtering atmosphere plays an important role in obtaining a semiconductor film having sufficient lattice distortions therein. In the case of hydrogen/argon mixtures, the hydrogen proportion is selected to be between 5% and 100% (therefore the argon proportion is between 95% and 0%), and typically is between 25% and 95% (argon between 75% and 5%).

The above and other features of the present invention will become clearer from consideration of the following detailed description of exemplary embodiments of the present invention given with reference to the accompanying drawings.

## DESCRIPTION OF THE DRAWINGS

Fig.1(A) is a schematic view showing a planar type magnetron RF sputtering apparatus suitable for use in manufacturing thin film field effect semiconductor transistors embodying the present invention;

Fig.1 (B) is an explanatory view showing the arrangement of magnets provided in the apparatus illustrated in Fig. 1(A);

Figs. 2(A) to 2(E) are cross-sectional views showing a method of manufacturing thin film field effect semiconductor transistors in accordance with a first embodiment of the present invention;

Fig.3 (A) is a graphical diagram showing the relationship between the partial pressure of hydrogen in the atmosphere in which semiconductor films are deposited and the field mobility of the semiconductor film;

Fig.3 (B) is a graphical diagram showing the relationship between the partial Pressure of hydrogen in the atmosphere in which semiconductor films are deposited and the threshold voltage of the transistor consisting of the semiconductor film;

Figs.4 to 8 are graphical diagrams showing the relationships between the drain current and the drain voltage of field effect transistors manufactured in accordance with an embodiment of present invention;

Fig.9 is a graphical diagram showing Raman spectra of semiconductor films deposited under several deposition conditions; and

Figs. 10(A) and 10(B) are cross-sectional views showing thin film field effect semiconductor transistors formed in accordance with second and third embodiments of the present invention.

## DETAILED DESCRIPTION OF THE EMBODIMENTS

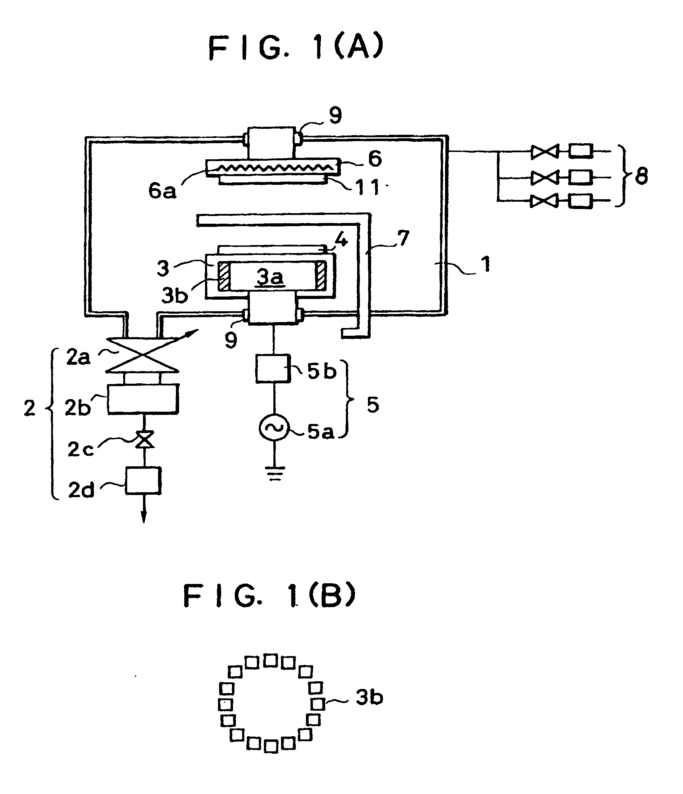

Referring to Fig.1 (A), a planar type magnetron RF sputtering apparatus suitable for use in manufacturing thin film field effect semiconductor transistors embodying the present invention is illustrated. The apparatus comprises a vacuum chamber 1, an evacuation system 2 consisting of a turbo molecular pump 2b and a rotary pump 2d respectively provided with valves 2a and 2c, a metallic holder 3 fixed in the lower side of the chamber 1 for supporting a target 4 thereon, the holder being formed with an inner conduit 3a through which a coolant can flow to cool the target 4 and being provided with a number of magnets 3b, an energy supply 5 consisting of an RF (e.g. 13.56MHz) source 5a provided with a matching box 5b for supply RF energy to the holder 3, a substrate holder 6 located in the upper side of the chamber 1 for supporting a substrate 11 to be coated, a heater 6a embedded in the substrate holder 6, a shutter 7 between the substrate 11 and the target 4 and a gas feeding system 8. Numeral 9 designates sealing means for ensuring the air-tight structure of the vacuum chamber 1. In advance of actual deposition on the substrate 11, impurities occurring in the targets are sputtered and deposited on the shutter 7 between the substrate 11 and the target 4, and then the shutter is removed in order to enable normal deposition on the substrate 11. The magnets 3b are oriented to have their N poles at their upper ends (as viewed in the figure) and S poles at their lower ends, and are horizontally arranged in a circle as illustrated in Fig.1 (B) in order to confine electrons in a sputtering region between the substrate 11 and the target 4.

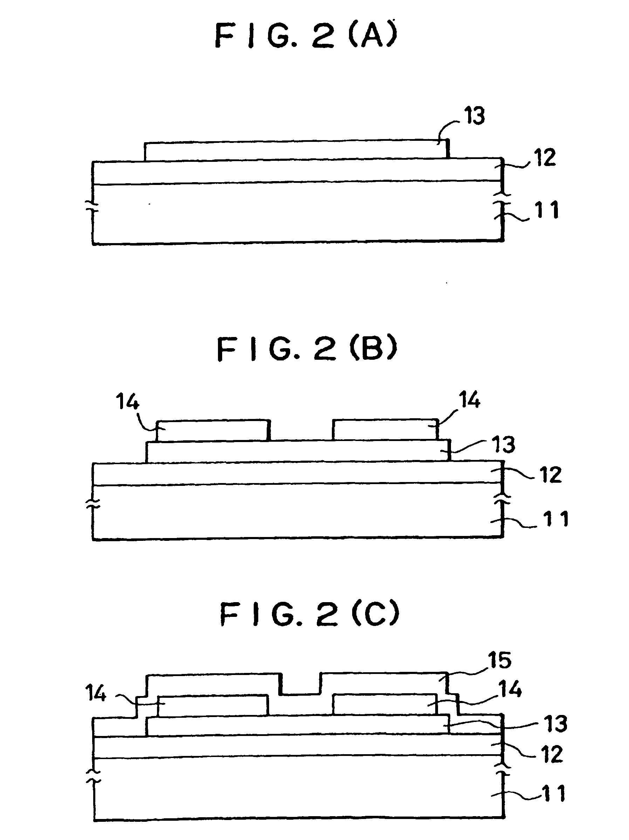

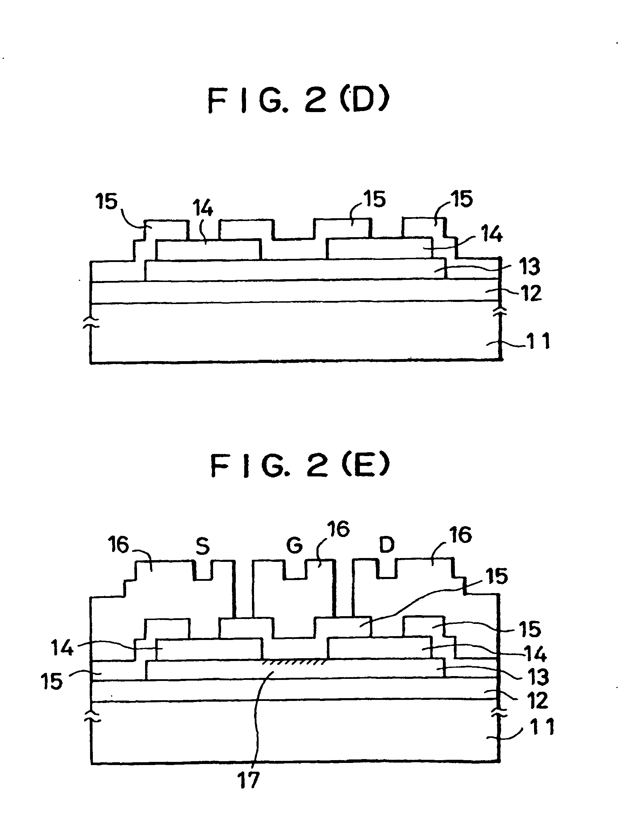

Referring now to Figs.2(A) to 2 (E), a method of manufacturing thin film field effect transistors in accordance with a first embodiment of the invention will be described.

A glass substrate 11 is disposed in the magnetron RF sputtering apparatus shown in Figs.1 (A) and 1 (B) and is coated with a $SiO_2$ film 12 to a thickness of 200nm in a 100% $O_2$ atmosphere (0.5 Pa) at a substrate temperature of 150°C. The output power of the apparatus is 400W in terms of 13.56 MHz RF energy. Single crystalline silicon is used as a target. An amorphous silicon film is then deposited in the sputtering apparatus on the $SiO_2$ film 12 to a thickness of 100nm. The atmosphere comprises a mixture consisting of hydrogen and argon so that $H_2/(H_2+Ar) = 0.8$ in terms of partial pressure. The total pressure is 0.5 Pa: the output power of the apparatus is 400W in terms of 13.56 MHz RF energy: single crystalline silicon is used as a target: and the substrate temperature is maintained at 150°C (deposition temperature) by the heater 6a. In one embodiment, the hydrogen proportion in the mixture is chosen between 5% and 100%; the deposition temperature between 50° C and 500° C; the output power between 100W and 10MW in a frequency range from 500Hz to 100GHz which may be combined with another pulse energy source.

The amorphous silicon film is then subjected to thermal treatment at 450° C to 700° C, typically at 600°C, for 10 hours in a hydrogen or an inert atmosphere, e.g. in 100% nitrogen. The film is recrystallized by this treatment. In accordance with experiments, it was confirmed by SIMS analysis that oxygen, carbon and hydrogen were involved respectively at densities of $2 \times 10^{20}$cm-3, $5 \times 10^{18}$cm-3 and no higher than 5%. These density figures were minimum values for the respective elements and varied along the depth direction. The reason why minimum values were measured is that a natural oxide existed at the surface of the semiconductor film. These concentrations were not changed even after the recrystallization.

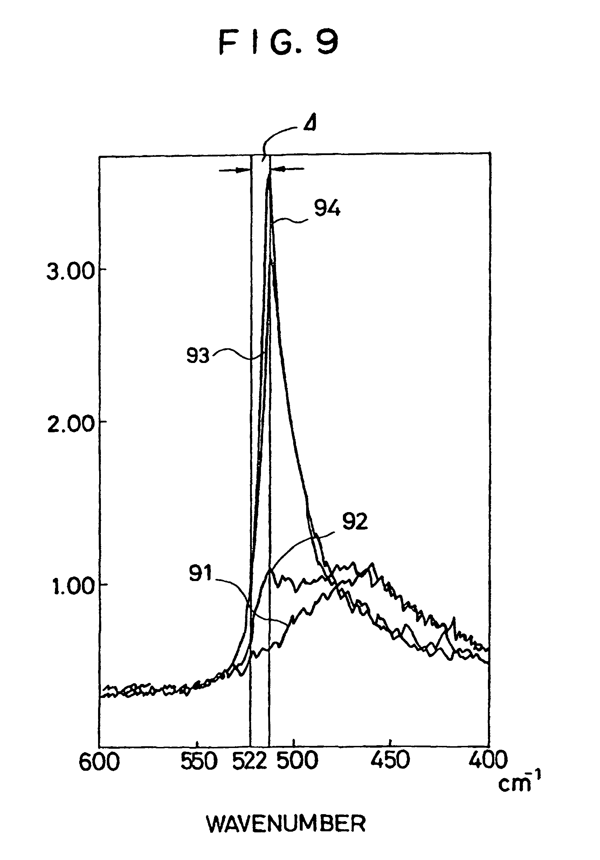

The impurities such as oxygen usually tend to be collected at interfaces between crystals and form interfacial barriers in the semiconductors. In the case of the semiconductor film formed according to the first embodiment of the present invention, however, lattice distortion prevents the formation of barriers and therefore oxygen concentrations, even of the order of $2 \times 10^{20}$cm-3, exert little influence upon the transportation of carriers and cause no practical problems. The existence of lattice distortions was indicated by a shift in a laser Raman spectra peak towards the lower wave number direction as shown in Fig.9, which will be explained later.

The semiconductor film is next etched to produce a pattern necessary to form a number of transistors in the substrate 11 in accordance with the following procedure. The film 13 shown in Fig.2(A) corresponds to one of the transistors to be formed.

Next, an $n^+$- type amorphous silicon semiconductor film is deposited on the film 13 in the magnetron RF sputtering apparatus to a thickness of 50 nm. The atmosphere comprises a mixture consisting of $H_2$ at 10% to 99%, e.g. 80%, Ar at 10% to 90%, e.g. 19% and $PH_3$, at no higher than 10%, e.g. no higher than 1% in terms of partial pressure. The total pressure is 0.5 Pa: the output power of the apparatus is 400W in terms of 13.56 MHz RF energy: a single crystalline silicon is used as a target: and the substrate temperature in the apparatus is maintained at 150° C. The doping with phosphorus may be performed by any other suitable technique, such as ion implantation or the use of a target in which a phosphorus impurity has been doped in advance. Boron may be used instead of phosphorous as a dopant. The impurity semiconductor film is then patterned to form source and drain regions 14 as shown in Fig.2(B) .

The entire surface of the structure is then coated with a silicon oxide film to a thickness of 100 nm by magnetron RF sputtering as illustrated in Fig.2(C). The atmosphere comprises a high density oxygen diluted with an inert gas, preferably, 100% oxygen at 0.5 Pa: the output- power of the apparatus is 400W in terms of 13.56 MHz RF energy: a single crystalline silicon or an artificial quartz is used as a target: and the substrate temperature is maintained at 100° C. When pure oxygen (100% oxygen) is used as the atmosphere, the surface level density of the gate insulating film can be decreased so that excellent transistor characteristics are realized.

After opening contact holes in the oxide film 15 as shown in Fig.2(D), an aluminum film 16 is deposited by vapor evaporation to a thickness of 300 nm and patterned in order to form a gate electrode G and source and drain contact electrodes S and D. Finally, the entire structure is subjected to thermal annealing in a 100% hydrogen atmosphere at 375° C for 30 minutes. The hydrogen thermal annealing is carried out for the purpose of lowering interfacial potentials and improving device characteristics. As a result, a thin film transistor is formed with a channel region of $100\mu$m x $100\mu$m. The properties of the transistor have been examined as will be described hereinafter.

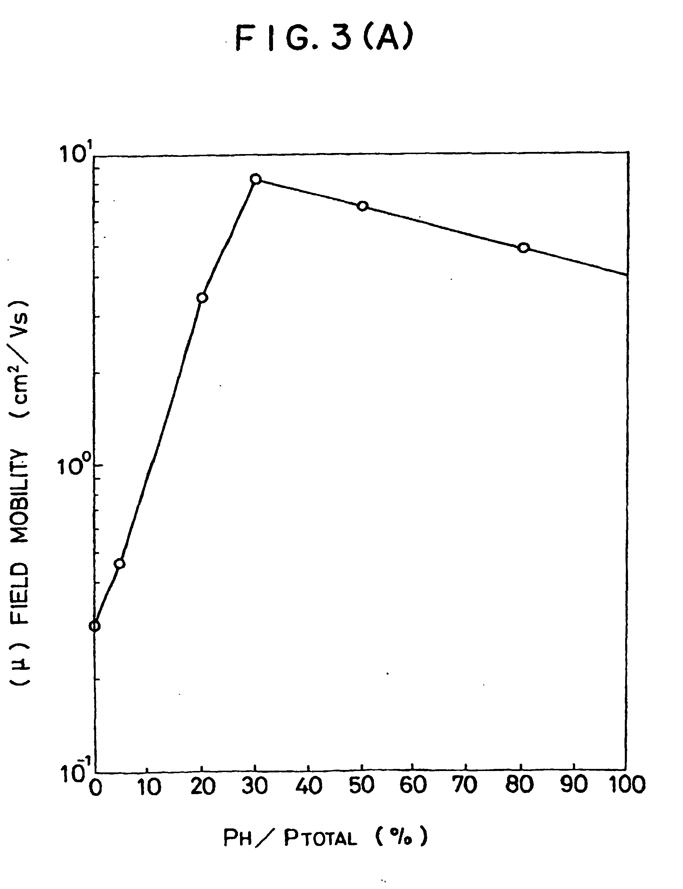

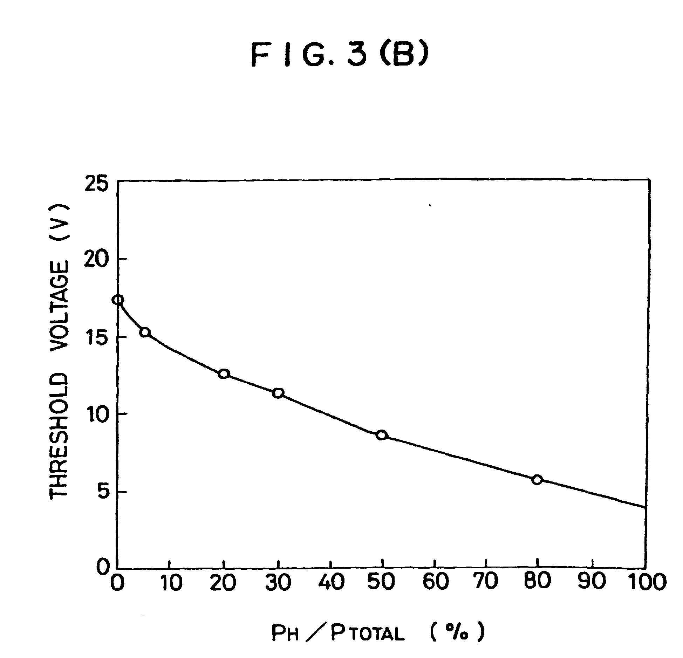

The above procedure was repeated under different deposition conditions for the semiconductor film 13. The proportion of hydrogen in the hydrogen/Ar mixture atmosphere was changed to be $H_2/(H_2+Ar) = 0, 0.05, 0.2, 0.3, 0.5$ and 0.8 respectively in term of partial pressure. Fig.3 (A) is a graphical diagram showing the field mobility versus the proportion of hydrogen ($P_M/P_{TOTAL}=H_2/(H_2+Ar)$). In accordance with this diagram, high values of the field mobility can be attained if the hydrogen proportion is no lower than 20%. Fig.3 (B) is a graphical diagram showing the threshold voltage versus the hydrogen proportion. As shown from this diagram, field effect transistors of normally off type can be formed to have threshold voltages of no higher than 8V, which is desirable from a practical view point, if the hydrogen proportion is no lower than that of argon. This means that transistors having good characteristics can be formed by fabricating channel regions by depositing amorphous silicon film through sputtering carried out in a hydrogen atmosphere and subjecting the film to thermal treatment. The electric characteristics tend to be improved as the hydrogen proportion is increased.

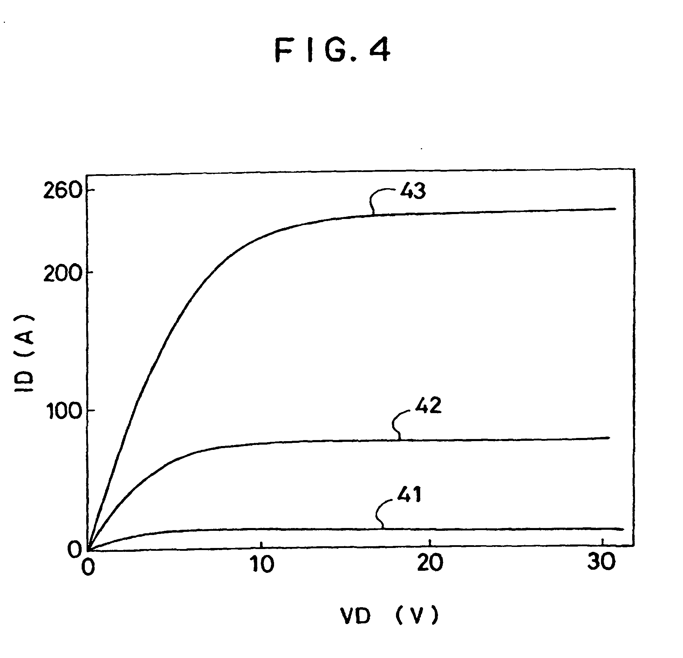

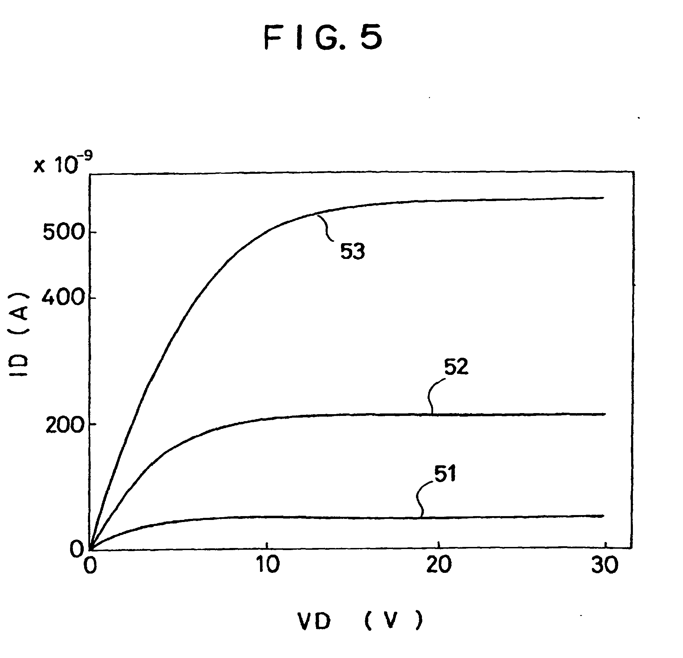

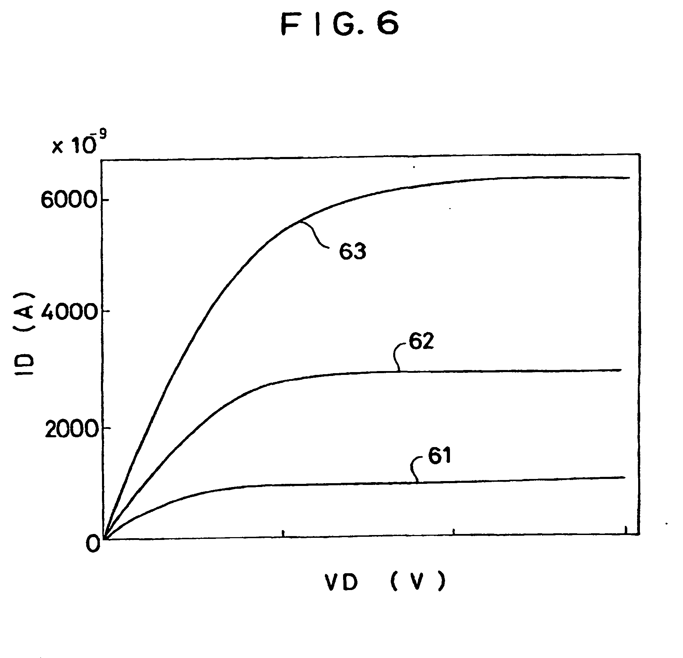

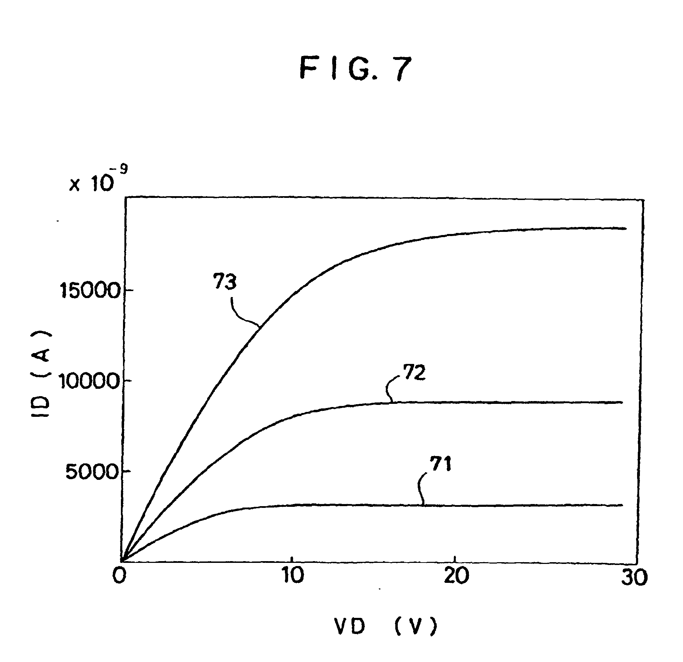

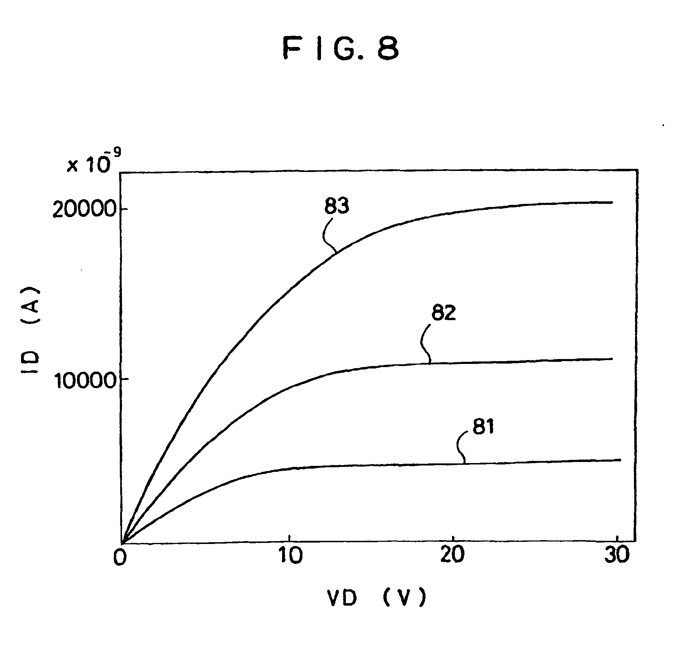

Figs.4 to 8 are graphical diagrams showing the relationship between the drain current and the drain voltage. The proportion of hydrogen of the hydrogen/Ar mixture atmosphere, i.e. $H_2/(H_2+Ar)$, were 0 (Fig.4), 0.05 (Fig.5), 0.2 (Fig.6). 0.3 (Fig.7) and 0.5 (Fig.8) respectively in term of partial pressure. Curves 41, 51, 61, 71, and 81 correspond to the case in which measurement was effected with the application of 20 V at the gate electrode. Curves 42, 52, 62, 72 and 82 correspond to the case in which measurement was effected with the gate electrode at 25 V. Curves 43, 53, 63, 73 and 83 correspond to the case in which measurement was effected with the gate electrode at 30 V. The conspicuous effect of the above described embodiment of the present invention is apparent when Fig.5 is compared with Fig.6. Namely, when curve 53 is compared to curve 63, it can be seen that the drain current in the case of the hydrogen proportion being 0.2 was larger than that when the hydrogen proportion was 0.05 by a factor of 10 or more. This means that the characteristics of transistors are significantly improved when the proportion of hydrogen in the atmosphere in which the amorphous silicon film 13 is deposited is increased from 5% to 20%. This is confirmed also by the following experiments.

The proportion of hydrogen of the hydrogen/Ar mixture atmosphere in which the channel region was deposited was changed to be $H_2/(H_2+Ar)$ = 0, 0.05, 0.2, 0.3 and 0.5 respectively in term of partial pressure. Fig. 9 is a graphical diagram showing Raman spectra of the semiconductor film 13 after the thermal treatment. The proportions of hydrogen of the hydrogen/Ar mixture atmosphere, i.e. $H_2/(H_2+Ar)$, were 0 (curve 91), 0.05 (92), 0.2 (curve 93) and 0.5 (curve 94) respectively in term of partial pressure. As shown in the diagram, the crystallinity was conspicuously enhanced when the hydrogen proportion was increased to 20% (curve 93) as compared with the case of 5% (curve 92). The average diameter of constituent crystals of the film in the case of 20% was 5Å to 400Å, typically 50Å to 300Å. The peak position of the Raman spectra was shifted to the small wave number direction by an amount $\Delta$ (approx. 10 cm$^{-1}$) with reference to the peak position for single crystalline silicon, i.e. 522cm$^{-1}$, and this shift indicates lattice distortion. The film is dense and therefore crystals thereof are contracted. Because of the contraction and the lattice distortion each crystal can be more closely connected with its neighbours and fewer impurities are collected at the interfaces, lowering the barrier height. As a result, high carrier mobilities can be realized even if the concentration of impurity in the film is as high as 2 x $10^{20}$cm$^{-3}$.

Referring to Figs. 6, 7 and 8 again, it will be understood that the drain current increases as the hydrogen proportion increases by comparing curves 63, 73 and 83 with each other. The drain current ID is expressed by the following equation when the drain voltage VD is low (Solid State Electronics, vol.24, No.11, p.1059, 1981, printed in Britain).

$$ID = (W/L)\mu C(VG-VT)VD$$

In the above equation, W is the channel width of the transistor; L is the channel length; $\mu$ is the carrier mobility; C is the static capacity of the gate insulating oxide film; VG is the gate voltage; and VT is the threshold voltage, Curves plotted in Figs. 4 to 8 can be expressed by the equation in the vicinity of the origin. The carrier mobility $\mu$ and the threshold voltage VT are determined by giving the hydrogen proportion in the atmosphere whereas the values W, L and C are determined by the geometric design of the transistor. Accordingly, the variables of the equation are 1D, VG and VD. Since, in Figs.4 to 8, curves are plotted with the variable VG being fixed, they are considered as two-variable functions expressed by the equation in the vicinity of the origin. The equation suggests that the gradient of each curve plotted in Figs.4 to 8 near the origin increases as the threshold voltage VT decreases and the mobility $\mu$ increases. This is apparent when comparing Figs.4 to 8 to each other with reference to the VT and $\mu$ of the respective cases which are shown in Figs.2 and 3. The equation also teaches the dependency of electric characteristics of the thin film transistor upon the VT and $\mu$ so that the device characteristics can not be determined only by one of Figs.2 and 3. when the gradients near origin of the respective curves plotted in Figs.4 to 8 are compared with each other for this reason, it is concluded that the hydrogen proportion should be not smaller than 20 %, preferably 100%.

This can be understood from the following consideration. Comparing Figs.4 to 8 with each other, the drain current increases as the hydrogen proportion increases toward 100% when the amorphous silicon film 13 is deposited by sputtering. This is apparent when comparing curves 43, 53, 63, 73 and 83.

The following is data showing the effects of the present embodiment:

| $H_2$ proportion | S | VT | $\mu$ | on/off ratio |
|---|---|---|---|---|
| 0 | 3.1 | 17.5 | 0.30 | 5.4 |
| 5 | 2.8 | 15.4 | 0.46 | 5.7 |
| 20 | 2.4 | 12.6 | 3.41 | 6.7 |
| 30 | 2.0 | 11.4 | 8.39 | 6.9 |
| 50 | 1.7 | 8.7 | 6.76 | 6.9 |
| 80 | 0.97 | 5.8 | 5.04 | 6.2 |

In the above data, $H_2$ proportion is the hydrogen proportion as discussed supra. S is the minimum value of [d

(ID) /d (VG)]$^{-1}$ of the drain current ID as a function of the gate voltage VG in the vicinity of origin. A smaller S indicates sharper rise of the ID-VG function and better electric characteristics of the transistor. VT is the threshold voltage. The "$\mu$" is the carrier mobility in units of $cm^2/V{\cdot}s$. The "on/off ratio" is the logarithm of the ratio of the drain current ID with VG being at 30V to the minimum value of the drain current ID when the drain voltage is fixed at 10V. From the data, it can be understood that it is preferred to choose a proportion of hydrogen in the sputtering atmosphere of 80% or more.

Referring now to Fig .10 (A), a thin film field effect transistor in accordance with a second embodiment of the present invention will be described. The deposition, the patterning and the thermal treatment of the insulating film 12 and the amorphous silicon film 13 are carried out in the same manner as the first embodiment. The entire structure is then coated with a 100nm thick silicon oxide film 15 by sputtering in an oxide atmosphere as described above. On the silicon oxide film 15 is deposited a polysilicon film which is highly doped with phosphorus followed by photolithography with a suitable mask in order to form a gate electrode 20.

With the gate electrode 20 or the mask used for forming it as a mask, self-aligned impurity regions, i.e. a source and a drain region 14 and 14' are formed by ion implantation. The intermediate region 17 of the silicon semiconductor film 13 between the impurity regions 14 and 14' is then defined as a channel region. Then, a thermal treatment may be carried out at 100° C to 500° C, for example 300° C, for 0.5 hour to 3 hours, for example 1 hour, in $H_2$ atmosphere in order to effect a thermal annealing. In this case, the interface state density is not more than $2 \times 10^{11}$ $cm^{-3}$. An interlayer insulating film is coated over the entire surface of the structure followed by etching for opening contact holes in the interlayer film and the oxide film 15 in order to provide access to the underlying source and drain regions 14 and 14' . Finally, an aluminum film is deposited on the structure over the contact holes and patterned to form source and drain electrodes 16 and 16'. In accordance with this embodiment, since the source and drain regions and the channel region are formed in the same semiconductor film therefore the process can be simplified and the carrier mobility in the source and drain regions is improved because of the crystallinity of the semiconductor film 13.

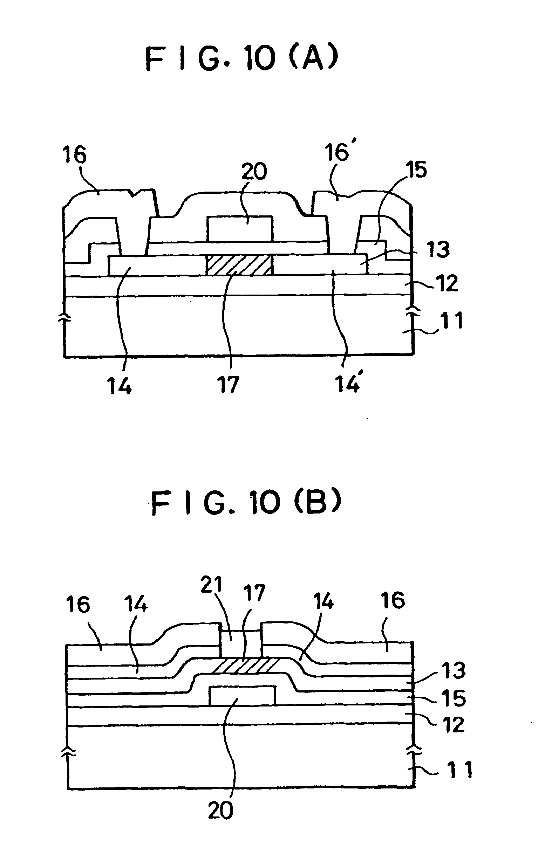

Referring to Fig.10(B), a thin film field effect transistor in accordance with a third embodiment of the present invention will be described. The deposition of the insulating film 12 is carried out in the same manner as the first embodiment. Next, however, a gate electrode 20 is formed by depositing and patterning a molybdenum film of a thickness of 3000Å as opposed to the case of the first embodiment.

The entire surface of the structure is then coated with a silicon oxide film 15 to a thickness of 100nm by magnetron RF sputtering. The atmosphere comprises a high density oxygen diluted with an inert gas, preferably, 100% oxygen at 0.5 Pa: the output power of the apparatus is 400W in terms of 13.56 MHz RF energy: a single crystalline silicon or an artificial quartz is used as a target: and the substrate temperature is maintained at 100°C. When pure oxygen (100% oxygen) is used as the atmosphere, the surface level density of the gate insulating film can be decreased so that excellent transistor characteristics are realized.

An amorphous silicon film is deposited in the sputtering apparatus on the silicon oxide film 15 to a thickness of 100 nm. The atmosphere comprises a mixture consisting of hydrogen and argon so that $H_2/ (H_2+Ar) = 0.8$ in terms of partial pressure. The total pressure is 0.5 Pa: the output power of the apparatus is 400w in terms of 13.56 MHz RF energy: a single crystalline silicon is used as a target: and the substrate temperature is maintained at 150°C in the same manner. The amorphous silicon film is then given thermal treatment at 450° C to 700° C, typically at 600° C for 10 hours in a hydrogen or an inert atmosphere, e.g. in 100% nitrogen. The film is recrystallized by this treatment to be polycrystalline. In accordance with experiments, it was confirmed by SIMS analysis that oxygen, carbon and hydrogen atoms were involved respective at $1 \times 10^{20}cm^{-3}$, $4 \times 10^{18}cm^{-3}$ and no higher than 5%. These figures of density were minimum values of the respective elements which varied along the depth direction. Thus, a channel region 17 is formed on the gate electrode 20 through the gate insulating film 15.

Next, an n$^+$- type amorphous silicon semiconductor film is deposited on the film 13 in the magnetron RF sputtering apparatus to a thickness of 50nm. The atmosphere comprises a mixture consisting of $H_2$ at 10% to 99%, e.g. 80%, Ar at 10% to 90%, e.g. 20% in terms of partial pressure. The total pressure is 0.5 Pa: the output power of the apparatus is 400W in terms of 13.56 MHz RF energy: a single crystalline silicon doped with phosphorus is used as a target: and the temperature in the apparatus is maintained at 150° C. The entire surface of the structure is coated with an aluminum film. The aluminum film and the n$^+$-type film are patterned to form source and drain regions 14 and 14' and source and drain electrodes 16 and 16'. A channel region 17 is defined just below a gap between the source and the drain regions 14 and 14'. The gap is filled with an insulator 21 for protecting the channel region 17.

In accordance with the third embodiment, since the gate insulating film 15 is formed in advance of the formation of the semiconductor film 13 forming the channel 17, the interface between the insulating film 15 and the channel 17 is readily thermal annealed so that the density of surface levels can be decreased.

The foregoing description of embodiments has been presented for purposes of illustration and description. It is not intended to be exhaustive or to limit the invention to the precise form described, and obviously many modifications and variations are possible in light of the above teaching. The embodiments were chosen in order to explain most clearly the principles of the invention and its practical application thereby to enable others in the art to utilize most effectively the invention in various embodiments and with various modifications falling within the scope of the claims and which are suited to the particular use contemplated. Examples are as follows:

Modifications which are not a part of the present invention can be applied to transistors utilizing other types of semiconductors such as germanium or silicon/germanium ($Si_xGe_{1-x}$) semiconductors, in which case the thermal treatment can be done at temperatures approx. 100°C lower than those used in the above embodiments. The deposition of such semiconductor can be carried out by sputtering in a high energy hydrogen plasma caused by optical energy (shorter than 1000nm wavelength) or electron cyclotron resonance (ECR). In this case, positive ions can be effectively produced so that the formation of microstructure in the semiconductor film thus deposited is further prevented. Instead of gases including hydrogen molecules, some hydrogen compounds can be used as the sputtering atmosphere so long as they do not give rise to impurities in the semiconductor. For example, monosilane or disilane may be used for forming silicon semiconductor transistors. And halogen such as helium may be used.

Field effect transistors in accordance with modifications of the embodied present invention may be manufactured by either of the following two ways, namely an amorphous silicon semiconductor film may be deposited by sputtering as defined in the claims, and an oxide insulating film (gate insulating film) may be deposited by sputtering in an atmosphere comprising oxygen.

An oxide insulating film (gate insulating film) may be deposited by any method. The semiconductor film can be deposited at a high deposition rate by sputtering and sputtering is suitable for mass production.

**Claims**

1. A method of manufacturing field effect transistors comprising:

   depositing an amorphous silicon semiconductor film (13) on an insulating surface (12) by sputtering in an atmosphere comprising a mixture consisting of hydrogen and an inert gas at a selected deposition temperature and a selected sputtering power and frequency;
   subjecting said amorphous silicon semiconductor film (13) to a crystallization treatment comprising an annealing to form a crystalline silicon semiconductor film;
   depositing an insulating film (15) on said crystalline silicon semiconductor film (13);
   forming a gate electrode (16, 20) over said crystalline silicon semiconductor film (13) with said insulating film (15) insulating said crystalline silicon semiconductor fibn (13) from said gate electrode in order to define a channel region (17) in said crystalline silicon semiconductor film (13) just below said gate electrode; and
   forming source and drain semiconductor regions (14, 14') adjacent to said channel region (17);

   **characterized by**:

   said insulating film (15) being an oxide film;
   said selected sputtering power and frequency being in the range of 100W to 10 MW and 500 Hz to 100 GHz respectively,
   said mixture having a hydrogen content in terms of partial pressure of 5% to 100%;
   said selected deposition temperature being in the range of 50 - 500°C;
   said annealing being carried out in an atmosphere of hydrogen or inert gas at a temperature of 450 - 700°C;
   and as the result of said depositing and crystallising of said amorphous silicon semiconductor film the Raman spectrum of the crystalline silicon semiconductor film (13) after the crystallization shows a peak at a wave number of less than 522 $cm^{-1}$.

2. The method of claim 1, wherein the oxide insulating film (15) is deposited by sputtering.

3. The method of claim 2, wherein the oxide insulating film (15) is deposited by sputtering in an atmosphere comprising oxygen.

4. The method of claim 1, wherein the oxide insulating film (15) is deposited by vapor deposition.

5. The method of any preceding claim wherein the step of forming said source and drain regions (14, 14') is carried out in advance of the step of forming said gate electrode (16, 20).

6. The method of claim 5 wherein said source and drain regions (14, 14') are formed by forming a patterned impurity doped amorphous silicon film on said crystalline silicon semiconductor film (13) in advance of the step of depositing the oxide insulating film (15).

7. The method of any of claims 1 to 4 wherein said source and drain regions (14, 14') are formed by implanting ions into said crystalline silicon semiconductor film (13) with said gate electrode (16, 20) as a mask.

8. A method of manufacturing field effect transistors comprising:

forming a gate electrode (20) on an insulating surface (12);
depositing an insulating film (15) over said gate electrode;
depositing an amorphous silicon semiconductor film (13) on said insulating film (15) by sputtering in an atmosphere comprising a mixture consisting of hydrogen and an inert gas at a selected deposition temperature and a selected sputtering power and frequency,
subjecting said amorphous silicon semiconductor film (13) to a crystallization treatment comprising an annealing to form a crystalline silicon semiconductor film having a channel region (17) defined by said gate electrode;
forming source and drain semiconductor regions (14, 14') adjacent to said channel region (17);

**characterized in that**:

said insulating film (15) is an oxide film;
said sputtering power and frequency being in the range of 100 W to 10 MW and 500 Hz to 100 GHz respectively;
said mixture having a hydrogen content in terms of partial pressure in the range of 5% to 100%;
said selected deposition temperature being in the range of 50 - 500°C;
said annealing being carried out in an atmosphere of hydrogen or inert gas at a temperature of 450 - 700°C; and
said depositing and crystallizing of said amorphous silicon semiconductor film being carried out under such conditions that the Raman spectrum of the crystalline silicon semiconductor film (13) after the crystallization shows a peak at a wave number of less than 522 cm$^{-1}$.

9. The method of claim 8 wherein the oxide insulating film (15) is deposited by sputtering.

10. The method of claim 9 wherein the oxide insulating film is deposited by sputtering in an atmosphere comprising oxygen.

11. The method of claim 8 wherein the oxide insulating film (15) is deposited by vapor deposition.

12. The method of any of claims 8 to 11 wherein said source and drain regions (14, 14') are formed by forming a patterned impurity doped amorphous silicon film on said crystalline silicon semiconductor film (13) except on said channel region (17).

13. The method of any preceding claim wherein said inert gas is argon.

14. The method of claim 13 wherein said hydrogen content of said mixture is 20%.

15. The method of any preceding claim wherein the crystalline silicon semiconductor film (13) after the crystallization includes hydrogen at a concentration not higher than 5 atomic %.

16. The method of any preceding claim, further comprising forming a SiO$_2$ film (12) on a glass substrate (11), said SiO$_2$ film (12) providing said insulating surface.

**Revendications**

1. Méthode pour fabriquer des transistors à effet de champ, consistant à :

- déposer un film semi-conducteur en silicium amorphe (13) sur une surface isolante (12) par pulvérisation cathodique dans une atmosphère contenant un mélange composé d'hydrogène et d'un gaz inerte, à une température de dépôt sélectionnée et à une puissance et une fréquence de pulvérisation cathodique sélectionnées ;
- soumettre le film semi-conducteur en silicium amorphe (13) à un traitement de cristallisation comprenant un recuit, pour former un film semi-conducteur en silicium cristallin ;
- déposer un film isolant (15) sur le film semi-conducteur en silicium cristallin (13) ;
- former une électrode de grille (16, 20) sur le film semi-conducteur en silicium cristallin (13), le film isolant (15) isolant ce dernier par rapport à l'électrode de grille afin de définir une zone de canal (17) dans le film semi-conducteur en silicium cristallin (13) juste au-dessous de l'électrode de grille ; et
- former des zones semi-conductrices de source et de drain (14, 14') près de la zone de canal (17) ;

**caractérisée en ce que**

- le film isolant (15) est un film d'oxyde ;
- la puissance et la fréquence de pulvérisation cathodique sélectionnées sont situées respectivement dans la plage de 100 W à 10 MW et de 500 Hz à 100 GHz ;
- le mélange a une teneur en hydrogène, en termes de pression partielle, de 5 % à 100 % ;
- la température de dépôt sélectionnée est située dans la plage de 50 à 500°C ;
- le recuit est réalisé dans une atmosphère d'hydrogène ou de gaz inerte à une température de 450 à 700°C ;
- et le résultat du dépôt et de la cristallisation du film semi-conducteur en silicium amorphe est que le spectre Raman du film semi-conducteur en silicium cristallin (13), après la cristallisation, présente un pic à un nombre d'onde inférieur à 522 cm$^{-1}$.

2. Méthode selon la revendication 1, selon laquelle le film isolant d'oxyde (15) est déposé par pulvérisation cathodique.

3. Méthode selon la revendication 2, selon laquelle le film isolant d'oxyde (15) est déposé par pulvérisation cathodique dans une atmosphère contenant de l'oxygène.

4. Méthode selon la revendication 1, selon laquelle le film isolant d'oxyde (15) est déposé par dépôt en phase vapeur.

5. Méthode selon l'une quelconque des revendications précédentes, selon laquelle l'étape de formation des zones de source et de drain (14, 14') est exécutée avant l'étape de formation de l'électrode de grille (16, 20).

6. Méthode selon la revendication 5, selon laquelle les zones de source et de drain (14, 14') sont formées grâce à la formation d'un film en silicium amorphe dopé aux impuretés et présentant un dessin, sur le film semi-conducteur en silicium cristallin (13), avant l'étape du dépôt du film isolant d'oxyde (15).

7. Méthode selon l'une quelconque des revendications 1 à 4, selon laquelle les zones de source et de drain (14, 14') sont formées grâce à l'implantation d'ions dans le film semi-conducteur en silicium cristallin (13) avec l'électrode de grille (16, 20) comme masque.

8. Méthode pour fabriquer des transistors à effet de champ, consistant à :

- former une électrode de grille (20) sur une surface isolante (12) ;
- déposer un film isolant (15) sur ladite électrode de grille ;
- déposer un film semi-conducteur en silicium amorphe (13) sur le film isolant (15) par pulvérisation cathodique dans une atmosphère contenant un mélange d'hydrogène et d'un gaz inerte, à une température de dépôt sélectionnée et à une puissance et une fréquence de pulvérisation cathodique sélectionnées ;
- soumettre le film semi-conducteur en silicium amorphe (13) à un traitement de cristallisation comportant un recuit, pour former un film semi-conducteur en silicium cristallin avec une zone de canal (17) définie par l'électrode de grille ;
- former des zones semi-conductrices de source et de drain (14, 14') près de la zone de canal (17) ;

**caractérisée en ce que :**

- le film isolant (15) est un film d'oxyde ;
- la puissance et la fréquence de pulvérisation cathodique sélectionnées étant situées respectivement dans la plage de 100 W à 10 MW et de 500 Hz à 100 GHz ;
- le mélange ayant une teneur en hydrogène, en termes de pression partielle, qui est située dans la plage de 5 % à 100 % ;
- la température de dépôt sélectionnée étant située dans la plage de 50 à 500°C ;
- le recuit étant réalisé dans une atmosphère d'hydrogène ou de gaz inerte à une température de 450 à 700°C ;
- et le dépôt et la cristallisation du film semi-conducteur en silicium amorphe étant réalisés dans des conditions telles que le spectre Raman du film semi-conducteur en silicium cristallin (13), après la cristallisation, présente un pic à un nombre d'onde inférieur à 522 cm$^{-1}$.

9. Méthode selon la revendication 8, selon laquelle le film isolant d'oxyde (15) est déposé par pulvérisation cathodique.

10. Méthode selon la revendication 9, selon laquelle le film isolant d'oxyde est déposé par pulvérisation cathodique dans une atmosphère contenant de l'oxygène.

11. Méthode selon la revendication 8, selon laquelle le film isolant d'oxyde (15) est déposé par dépôt en phase vapeur.

12. Méthode selon l'une quelconque des revendications 8 à 11, selon laquelle les zones de source et de drain (14, 14') sont formées grâce à la formation d'un film en silicium amorphe dopé aux impuretés et présentant un dessin, sur le film semi-conducteur en silicium cristallin (13), sauf sur la zone de canal (17).

13. Méthode selon l'une quelconque des revendications précédentes, selon laquelle le gaz inerte est de l'argon.

14. Méthode selon la revendication 13, selon laquelle le contenu d'hydrogène du mélange représente 20 %.

15. Méthode selon l'une quelconque des revendications précédentes, selon laquelle le film semi-conducteur en silicium cristallin (13), après la cristallisation, contient de l'hydrogène suivant une concentration qui ne dépasse pas 5 % atomique.

16. Méthode selon l'une quelconque des revendications précédentes, consistant également à former un film de $SiO_2$ (12) sur un substrat en verre (11), ce film de $SiO_2$ (12) formant la surface isolante.

## Patentansprüche

1. Verfahren zum Herstellen von Feldeffekttransistoren, umfassend:

Aufbringen eines amorphen Siliziumhalbleiterfilms (13) auf eine isolierende Fläche (12) durch Sputtern in einer Atmosphäre, die eine Mischung bestehend aus Wasserstoff und einem Edelgas umfasst, bei einer gewählten Aufbringtemperatur und einer gewählten Sputterleistung und -frequenz;
Unterwerfen des amorphen Siliziumhalbleiterfilms (13) einer Kristallisierungsbehandlung, die ein Tempern umfasst, um einen kristallinen Siliziumhalbleiterfilm zu erzeugen;
Aufbringen eines isolierenden Films (15) auf den kristallinen Siliziumhalbleiterfilm (13);
Ausbilden einer Steuerelektrode (16, 20) über dem kristallinen Siliziumhalbleiterfilm (13), wobei der isolierende Film (15) den kristallinen Siliziumhalbleiterfilm (13) von der Steuerelektrode isoliert, um einen Kanalbereich (17) im kristallinen Siliziumhalbleiterfilm (13) direkt unterhalb der Steuerelektrode zu definieren; und
Ausbilden von Source- und Drain-Halbleiterbereichen (14, 14') benachbart zum Kanalbereich (17);

**gekennzeichnet durch**:

den isolierenden Film (15), der ein Oxidfilm ist;
die gewählte Sputterleistung und -frequenz, die im Bereich von 100 W bis 10 MW bzw. im Bereich von 500 Hz bis 100 GHz liegt;
einen Wasserstoffgehalt der Mischung hinsichtlich des Partialdrucks von 5 % bis 100 % besitzt;
eine gewählte Aufbringtemperatur im Bereich von 50 bis 500 °C;
die Durchführung des Temperns in einer Wasserstoff- oder Edelgasatmosphäre bei einer Temperatur von 450 bis 700 °C;
und, als Ergebnis des Aufbringens und Kristallisierens des amorphen Siliziumhalbleiterfilms, einen Peak bei einer Wellenzahl von weniger als 522 cm$^{-1}$ im Raman-Spektrum des kristallinen Siliziumhalbleiterfilms (13) nach der Kristallisierung.

2. Verfahren nach Anspruch 1, wobei der Oxidisolierfilm (15) durch Sputtern aufgebracht wird.

3. Verfahren nach Anspruch 2, wobei der Oxidisolierfilm (15) durch Sputtern in einer Atmosphäre aufgebracht wird, die Sauerstoff umfasst.

4. Verfahren nach Anspruch 1, wobei der Oxidisolierfilm (15) durch Aufdampfen aufgebracht wird.

5. Verfahren nach einem der vorhergehenden Ansprüche, wobei der Schritt des Ausbildens der Source- und Drain-Bereiche (14, 14') vor dem Schritt des Ausbildens der Steuerelektrode (16, 20) ausgeführt wird.

6. Verfahren nach Anspruch 5, wobei die Source- und Drain-Bereiche (14, 14') vor dem Schritt des Aufbringens des Oxidisolierfilms (15) durch Ausbilden eines strukturiert mit Fremdatomen dotierten amorphen Siliziumfilms auf dem kristallinen Siliziumhalbleiterfilm (13) ausgebildet werden.

7. Verfahren nach einem der Ansprüche 1 bis 4, wobei die Source- und Drain-Bereiche (14, 14') durch Implantation von Ionen in den kristallinen SiliziumHalbleiterfilm (13) ausgebildet werden, wobei die Steuerelektrode (16, 20) als Maske dient.

8. Verfahren zum Herstellen von Feldeffekttransistoren, umfassend:

   Ausbilden einer Steuerelektrode (20) auf einer isolierenden Fläche (12);
   Aufbringen eines isolierenden Films (15) auf die Steuerelektrode;
   Aufbringen eines amorphen Siliziumhalbleiterfilms (13) auf den isolierenden Film (15) durch Sputtern in einer Atmosphäre, die eine Mischung bestehend aus Wasserstoff und einem Edelgas umfasst, bei einer gewählten Aufbringtemperatur und einer gewählten Sputterleistung und -frequenz;
   Unterwerfen des amorphen Siliziumhalbleiterfilms (13) einer Kristallisierungsbehandlung, die ein Tempern zum Ausbilden eines kristallinen Siliziumhalbleiterfilms umfasst, der einen Kanalbereich (17) besitzt, der durch die Steuerelektrode definiert ist;
   Ausbilden von Source- und Drain-Halbleiterbereichen (14, 14') benachbart zum Kanalbereich (17);

   **dadurch gekennzeichnet, dass**:

   der isolierende Film (15) ein Oxidfilm ist;
   die Sputterleistung und -frequenz im Bereich von 100 W bis 10 MW bzw. von 500 Hz bis 100 GHz liegt;
   die Mischung in Bezug auf den Partialdruck einen Wasserstoffgehalt von 5 % bis 100 % besitzt;
   die gewählte Aufbringtemperatur im Bereich von 50 bis 500 °C liegt;
   das Tempern in einer Atmosphäre aus Wasserstoff oder einem Edelgas bei einer Temperatur von 450-700 °C ausgeführt wird; und
   das Aufbringen und Kristallisieren des amorphen Siliziumhalbleiterfilms unter solchen Bedingungen ausgeführt werden, dass das Raman-Spektrum des kristallinen Siliziumhalbleiterfilms (13) nach dem Kristallisieren bei einer Wellenzahl von weniger als 522 cm$^{-1}$ einen Peak aufweist.

9. Verfahren nach Anspruch 8, wobei der Oxidisolierfilm (15) durch Sputtern aufgebracht wird.

10. Verfahren nach Anspruch 9, wobei der Oxidisolierfilm durch Sputtern in einer Atmosphäre, die Sauerstoff umfasst, aufgebracht wird.

11. Verfahren nach Anspruch 8, wobei der Oxidisolierfilm (15) durch Aufdampfen aufgebracht wird.

12. Verfahren nach einem Ansprüche 8 bis 11, wobei die Source- und Drain-Bereiche (14, 14') durch Ausbilden eines strukturiert mit Fremdatomen dotierten amorphen Siliziumhalbleiterfilms auf dem kristallinen Siliziumhalbleiterfilm (13) mit Ausnahme des Kanalbereichs (17) ausgebildet werden.

13. Verfahren nach einem der vorherigen Ansprüche, wobei das Edelgas Argon ist.

14. Verfahren nach Anspruch 13, wobei der Wasserstoffgehalt der Mischung 20 % beträgt.

15. Verfahren nach einem der vorherigen Ansprüche, wobei der kristalline Siliziumhalbleiterfilm (13) nach dem Kristallisieren Wasserstoff mit einer Konzentration von nicht mehr als 5 Atomprozent enthält.

16. Verfahren nach einem der vorherigen Ansprüche, ferner umfassend das Ausbilden eines $SiO_2$-Films (12) auf einem Glasträger (11), wobei der $SiO_2$-Film (12) die isolierende Fläche bereitstellt.

# FIG. 1(A)

# FIG. 1(B)

# F I G. 2 (A)

13

12

11

# F I G. 2 (B)

14

14

13

12

11

# F I G. 2 (C)

15

14

14

13

12

11

# F I G. 2 (D)

# F I G. 2 (E)

# F I G. 3 (A)

# F I G. 3 (B)

# F I G. 4

# F I G. 5

# F I G. 6

# F I G. 7

# F I G. 8

# F I G. 9

WAVENUMBER

F I G. 10 (A)

F I G. 10 (B)